(19) Europäisches Patentamt
European Patent Office
Office européen des brevets

(11) EP 0 507 375 B1

(12) **EUROPEAN PATENT SPECIFICATION**

(45) Date of publication and mention
of the grant of the patent:
**20.08.1997   Bulletin 1997/34**

(51) Int Cl.⁶: **G06F 17/60**, G06F 17/50

(21) Application number: **92200737.2**

(22) Date of filing: **16.03.1992**

(54) **Method of determining free subareas and free spaces**

Verfahren zum Ermitteln von freien Teilbereichen und freien Räumen

Procédé de détermination de surfaces libres et d'espaces libres

(84) Designated Contracting States:
**AT BE CH DE DK ES FR GB GR IT LI LU NL PT SE**

(30) Priority: **19.03.1991  NL 9100483**

(43) Date of publication of application:
**07.10.1992   Bulletin 1992/41**

(73) Proprietor: **Koninklijke PTT Nederland N.V.**
**2509 CH Den Haag (NL)**

(72) Inventor: **Snellen, Theodorus Cornelis**
**Christianus Maria**
**NL-2593 VR The Hague (NL)**

(56) References cited:
**US-A- 3 705 410**

• **COMPUTERS AND GRAPHICS vol. 10, no. 3, 1986, OXFORD, GB pages 229 - 237; S.A. SEGENREICH ET AL.: 'OPTIMAL NESTING OF GENERAL PLANE FIGURES: A MONTE CARLO HEURISTICAL APPROACH'**
• **IBM TECHNICAL DISCLOSURE BULLETIN. vol. 11, no. 5, October 1986, NEW YORK, US pages 535 - 539; O. GUREL: 'OPTIMAZATION OF IRREGULAR PATTERN LAYOUTS'**
• **JOURNAL OF PARALLEL AND DISTRIBUTED COMPUTING vol. 9, no. 1, May 1990, DULUTH, MN, US pages 63 - 68; F. DEHNE: 'Computing the Largest Empty Rectangle on One- and Two-Dimensional Processor Arrays'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The invention relates to a method of determining free subareas on an area partially covered with rectangular objects and also to a method of determining free spaces in a space partially filled with objects in the form of a right parallelepiped.

The determination of the most favourable area division in cutting essentially rectangular objects out of a sheet or plate of material, such as leather or metal, and also the positioning of objects in a space, such as the positioning of postal packages in a container used by the post office, and the positioning of containers having different dimensions in a cargo space of, for example, a ship has hitherto been done mainly by hand, with a member of staff attempting to achieve an optimum material utilisation or packing density on the basis of his experience. It will be clear that it is desirable to at least partially automate this cutting or packing, in particular if it is to be accompanied by a reduction in the material loss or an increase in the packing density, respectively, that is to say a more optimum use of the available material or the available space. A problem in this connection is that the calculation of the free subareas on an area partially filled with objects or free spaces in a space partially filled with objects is very complex, in particular if the objects already positioned have different dimensions. In addition, the calculations are always to be carried out again after positioning a new object.

The object of the invention is to simplify the abovementioned problem to such an extent that it is possible to calculate, with an acceptable calculation time, the free subareas on an essentially rectangular area partially filled with essentially rectangular objects or the free spaces in a space having essentially the form of a right parallelepiped partially filled wich objects having essentially the form of a parallelepiped, the calculation of the free subareas or spaces which are always produced after positioning a new object also being relatively simple.

For this purpose, the invention provides a method of determining free subareas on an area partially covered with objects in the form of a rectangle, in which method an essentially rectangular area to be covered having dimensions X and Y is depicted in the form of a two-dimensional matrix $(x, y)$, having x rows and y columns, each element of the matrix representing a rectangle on the area and it being established for each element whether the corresponding rectangle in the area is free or occupied, the corresponding element of the matrix being assigned a first logic value (A) in the first mentioned case and a second logic value (B) in the case mentioned second, there being a free subarea on the area if $(x_l,y_l) = B$ and $(x_{l-1},y_l) = A$ and $(x_l,y_{l-1}) = A$ and $(x_{l+1},y_l) = A$ and $(x_l,y_{l+1}) = A$ (I) for the corresponding element in the matrix; a matrix reduction being carried out, after determining the elements $x_l,y_l$ which satisfy (I), by always reducing by one the number of rows or the number of columns in the matrix in a predetermied sequence in consecutive steps until a (1,1) matrix or a null matrix is left, the possible free subareas always being determined after a reduction step with the aid of (I); the number of rows being reduced by deriving one row from predetermined rows L, L+1 by determining, for each element $(x_l,y_l)$ of each row, whether $(x_l,y_l) = B$ and $(x_{l+1},y_l) = B$ (II), in which case the element $(x_l,y_l)' := B$ in the reduced matrix $(x,y)'$, and if (II) is not satisfied, the element $(x_l,y_l)' := A$; the number of columns being reduced by deriving one column from predetermined columns l, l+1 by determining, for each element $(x_l,y_l)$ of each column, whether $(x_l,y_l) = B$ and $(x_l,y_{l+1}) = B$ (III), in which case the element $(x_l,y_l)' := B$ in the reduced matrix $(x,y)'$ and if (III) is not satisfied, the element $(x_l,y_l)' := A$; the dimensions of the free subareas determined using (I) being determined by creating a dimension table both for the rows and for the columns of the matrix, and by adjusting the dimension table for the rows or for the columns in a corresponding step during the matrix reduction to sum the dimensions of the rows or columns l, l+1.

The invention also provides a method for determining free spaces in a space partially filled with objects having essentially the form of a right parallelepiped, in which method the space to be filled and essentially having the form of a right parallelepiped and having dimensions X, Y and Z is depicted in the form of a three-dimensional matrix $(x, y, z)$ having x rows, y columns and z layers, each element of the matrix representing a right parallelepiped in the space and it being established for each element whether the corresponding right parallelepiped in the space is free or is occupied, the corresponding element of the associated matrix being assigned a first logic value (A) in the first mentioned case and a second logic value (B) in the case mentioned second, there being a free space in the space if $(x_l,y_l,z_l) = B$ and $(x_{l-1},y_l,z_l) = A$ and $(x_l,y_{l-1},z_l) = A$ and $(x_{l+1},y_l,z_l) = A$ and $(x_l,y_{l+1},z_l) = A$ and $(x_l,y_l,z_{l-1}) = A$ and $(x_l,y_l,z_{l+1}) = A$ (IV) for the corresponding element in the matrix; a matrix reduction being carried out, after determining the elements $(x_l,y_l,z_l)$ which satisfy (IV), by reducing by one the number of rows or the number 5 of columns or the number of layers of the matrix in a predetermined sequence in consecutive steps until a (1,1,1) matrix or a null matrix is left, the possible free spaces always being determined after a reduction step with the aid of (IV); the number of rows being reduced by deriving one row from predetermined row l, l+1 by determining, for each element $(x_l, y_l, z_l)$ of the matrix, whether $(x_l, y_l, z_l) = B$ and $(x_{l+1}, y_l, z_l) = B$ (V), in which case the element $(x_l, y_l, z_l)' := B$ in the reduced matrix $(x, y, z)'$, and if (V) is not satisfied, the element $(x_l, y_l, z_l)' = A$; the number of columns being reduced by deriving one column from predetermined columns L, L+1 by determining whether $(x_l, y_l, z_l) = B$ and $(x_l, y_{l+1}, z_l) = B$ (VI), in which case the element $(x_l, y_l, z_l)' := B$ in the reduced matrix $(x, y, z)'$, and if (VI) is not satisfied, the element $(x_l, y_l, z_l)' := A$; the number of layers being reduced by deriving one layer from predetermined layers L, l+1 by determining whether $(x_l, y_l, z_l) = B$ and $(x_l, y_l, z_{l+1}) = B$ (VII), in

which case the element $(x_l, y_l, z_l)' := B$ in the reduced matrix $(x, y, z)'$, and if (VII) is not satis-fied, the element $(x_l, y_l, z_l)' = A$; the dimensions of the free spaces determined using (IV) being determined by creating a dimension table for the rows and for the columns and for the layers of the matrix, and by adjusting the dimension table for the rows or the columns or the layers in a corresponding step during the matrix reduction to sum the dimensions of rows, columns or layers L, L+1.

As will be explained in greater detail below, the measures according to the invention make it possible to determine in all cases the remaining free areas or spaces accurately in the case, which occurs very often in practice, of positioning essentially rectangular objects on an essentially rectangular area or of positioning objects having an essentially right parallelepiped shape in a space having an essentially right parallelepiped shape, with the result that it becomes possible, on the basis of the dimensions of the objects still to be positioned on the area or in the space, which dimensions are stored, for example, in a memory, to automatically select the object whose dimensions approximate most closely those of the free areas or spaces found. On the basis of the available data of the objects to be positioned, it is also possible to select a cargo space or container having optimum dimensions.

The invention will be explained in greater detail below on the basis of an illustrative example with reference to the drawing in which the determination of the free subareas on a rectangular base area has been chosen for the sake of simplicity and clarity, the principle according to the invention also being readily applicable, however, to three-dimensional spaces, as will be explained schematically below.

In the drawing:

Figure 1a: shows schematically an area filled with ten packages;
Figure 1b: shows schematically a matrix representation of the situation shown in Figure 1a; and
Figure 2 shows schematically the free subareas found with the aid of the method according to the invention.

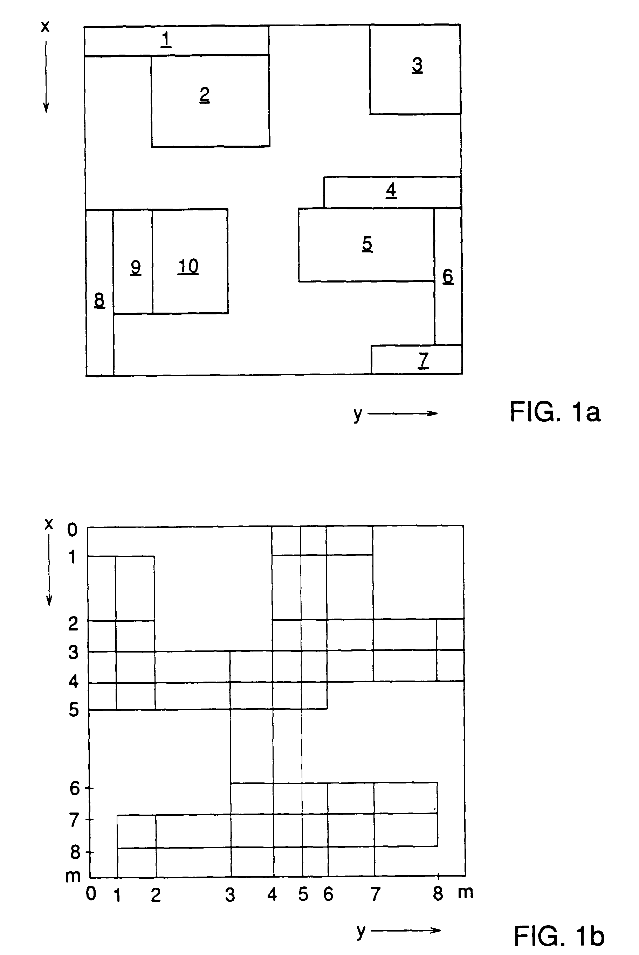

Figure 1a shows a rectangular area with ten rectangular objects 1 to 10 inclusive lying on it which, together with the boundary of the area, determine the free subareas. Figure 1b illustrates the conversion of the situation shown in Figure 1a to a matrix representation, which representation can be reproduced as follows if $A = 0$ is assumed for the first logic value and $B = 1$ is assumed for the second logic value:

```
           y=  1  2  3  4  5  6  7  8  9
     x=       _____

      1    ¦   0  0  0  0  1  1  1  0  0
      2    ¦   1  1  0  0  1  1  1  0  0
      3    ¦   1  1  0  0  1  1  1  1  1
      4    ¦   1  1  1  1  1  1  1  1  1
      5    ¦   1  1  1  1  1  1  0  0  0
      6    ¦   0  0  0  1  1  0  0  0  0
      7    ¦   0  0  0  1  1  1  1  1  0
      8    ¦   0  1  1  1  1  1  1  1  0
      9    ¦   0  1  1  1  1  1  1  0  0
```

To determine the dimensions of the free spaces found, two tables are updated whose length corresponds to the number of rows and columns, respectively, of the matrix:

| x | y |
|---|---|
| 0 - x1 | 0 - y1 |
| x1 - x2 | y1 - y2 |
| x2 - x3 | y2 - y3 |
| x3 - x4 | y3 - y4 |
| x4 - x5 | y4 - y5 |

(continued)

| x | y |
|---|---|
| x5 - x6 | y5 - y6 |
| x6 - x7 | y6 - y7 |
| x7 - x8 | y7 - y8 |
| x8 - xm | y8 - ym |

For the sake of completeness, it is pointed out that the illustrative example shown only shows an instantaneous picture during the process of positioning objects. Right at the beginning, the area is empty and the matrix is a (1,1) matrix and the dimension tables each contain one dimension, 0 - xm and 0 - ym, respectively; whenever an object is positioned, the dimensions of the matrix increase by not more than two rows and two columns and the dimension tables each increase by not more than two dimensions, unless the object positioned is adjacent to an object already present, in which case as will also be explained in greater detail below, the increase in the size of the matrix and the length of the dimension tables is smaller.

In order to find the free spaces in the illustrative example shown, the matrix is examined for the 'ones' which are bounded on four sides by 'zeros'. There is therefore a free subarea if $(x_l, y_l) = 1$ and $(x_{l-1}, y_l) = 0$ and $(x_l, y_{l-1}) = 0$ and $(x_{l+1}, y_l) = 0$ and $(x_l, y_{l+1}) = 0$ (I) for any element $x_l, y_l$ of the matrix.

Starting from the original matrix, the free areas having the smallest dimensions are found in this way. Searching for larger free subareas in this way would, however, quickly become fairly complex in this case and, in addition, would always require a function other than that according to (I) for each possible dimension of a free subarea. According to the invention, this problem is solved by reducing the matrix in rows and in columns, as will be explained further below, free subareas being found after reducing once in the x-direction using (I) with $x = 2$ and $y = 1$ as dimension, free subareas being found after reducing twice in the x-direction using (I) with $x = 3$ and $y = 1$ as dimension, free subareas being found after reducing once in the y-direction using (I) with $x = 1$ and $y = 2$ as dimension, etc. In determining the free subareas in this way, there is the possibility that free subareas partly overlapping one another are found, but this is not a drawback if, every time the free subareas have been calculated and a package has been positioned on the basis thereof, all the free subareas then available are again recalculated using (I) and using the consecutive steps of the complete matrix reduction.

The matrix, which is a representation of the packages positioned according to Figure 1a, is reduced in accordance with the 'tree' below.

```
(9,9)_(8,9)_(7,9)_(6,9)_(5,9)_(4,9)_(3,9)_(2,9)_(1,9)
      ¦
(9,8)_(8,8)_(7,8)_(6,8)_(5,8)_(4,8)_(3,8)_(2,8)_(1,8)
      ¦
(9,7)_(8,7)_(7,7)_(6,7)_(5,7)_(4,7)_(3,7)_(2,7)_(1,7)
      ¦
(9,6)_(8,6)_(7,6)_(6,6)_(5,6)_(4,6)_(3,6)_(2,6)_(1,6)
      ¦
(9,5)_(8,5)_(7,5)_(6,5)_(5,5)_(4,5)_(3,5)_(2,5)_(1,5)
      ¦
(9,4)_(8,4)_(7,4)_(6,4)_(5,4)_(4,4)_(3,4)_(2,4)_(1,4)
      ¦
(9,3)_(8,3)_(7,3)_(6,3)_(5,3)_(4,3)_(3,3)_(2,3)_(1,3)
      ¦
(9,2)_(8,2)_(7,2)_(6,2)_(5,2)_(4,2)_(3,2)_(2,2)_(1,2)
      ¦
(9,1)_(8,1)_(7,1)_(6,1)_(5,1)_(4,1)_(3,1)_(2,1)_(1,1)
```

The reduction is done for the row direction or x-direction according to the formula below:

If $(x,y)=1$ and $(x+1,y)=1$, then $(x,y):=1$, otherwise $(x,y):=0$.

The reduction in the column direction or y-direction is carried out in the same way with the necessary changes.

The various steps during the reduction of the matrix are consecutively numbered and each is subdivided into

a): the reduction and

b): the search for free subareas.

After each reduction step in the x- or y-direction, the appropriate dimension table is also adjusted by shifting the right-hand column of said table one position higher and deleting the last (lowermost) element in the left-hand column.

The process is started by searching for free subareas in the original matrix:

1b) searching for free subareas

In the original matrix, no 'ones' are bounded on all sides by 'zeros' and therefore there are no free subareas.

2a) The dimension of the matrix in the x-direction is reduced to an (8 x 9) matrix:

```
         y= 1 2 3 4 5 6 7 8 9          x                y

  x  = _____    _____      _____

      1  ¦ 0 0 0 0 1 1 1 0 0      0   - x2        0   - y1

      2  ¦ 1 1 0 0 1 1 1 0 0      x1  - x3        y1  - y2

      3  ¦ 1 1 0 0 1 1 1 1 1      x2  - x4        y2  - y3

      4  ¦ 1 1 1 1 1 1 0 0 0      x3  - x5        y3  - y4

      5  ¦ 0 0 0 1 1 0 0 0 0      x4  - x6        y4  - y5

      6  ¦ 0 0 0 1 1 0 0 0 0      x5  - x7        y5  - y6

      7  ¦ 0 0 0 1 1 1 1 1 0      x6  - x8        y6  - y7

      8  ¦ 0 1 1 1 1 1 1 0 0      x7  - xm        y7  - y8

                                                  y8  - ym
```

2b) There are no free subareas.

3a) The dimension of the matrix is reduced in the x-direction to a (7 x 9) matrix:

```
         y= 1 2 3 4 5 6 7 8 9          x                y

  x  = _____    _____      _____

      1  ¦ 0 0 0 0 1 1 1 0 0      0   - x3        0   - y1

      2  ¦ 1 1 0 0 1 1 1 0 0      x1  - x4        y1  - y2

      3  ¦ 1 1 0 0 1 1 1 0 0      x2  - x5        y2  - ..

      4  ¦ 0 0 0 1 1 0 0 0 0      x3  - x6        ..  - ..

      5  ¦ 0 0 0 1 1 0 0 0 0      x4  - x7        ..  - y8

      6  ¦ 0 0 0 1 1 0 0 0 0      x5  - x8        y8  - ym

      7  ¦ 0 0 0 1 1 1 1 0 0      x6  - xm
```

3b) There are no free subareas.

4a) The dimension of the matrix is reduced in the x-direction to a (6 x 9) matrix:

```
         y= 1 2 3 4 5 6 7 8 9          x                y

  x  = _____    _____      _____

      1  ¦ 0 0 0 0 1 1 1 0 0      0   - x4        0   - y1

      2  ¦ 1 1 0 0 1 1 1 0 0      x1  - x5        y1  - y2

      3  ¦ 0 0 0 0 1 0 0 0 0      x2  - x6        y2  - ..

      4  ¦ 0 0 0 1 1 0 0 0 0      x3  - x7        ..  - ..

      5  ¦ 0 0 0 1 1 0 0 0 0      x4  - x8        ..  - y8

      6  ¦ 0 0 0 1 1 0 0 0 0      x5  - xm        y8  - ym
```

4b) There are no free subareas.

5a) The dimension of the matrix is reduced in the x-direction to a (5 x 9) matrix:

6

```
        y= 1 2 3 4 5 6 7 8 9          x                y

  x =_____      _____        _____
    1  ¦ 0 0 0 0 1 1 1 0 0        0   - x5          0   - y1
    2  ¦ 0 0 0 0 1 0 0 0 0        x1  - x6          y1  - y2
    3  ¦ 0 0 0 0 1 0 0 0 0        x2  - x7          y2  - ..
    4  ¦ 0 0 0 1 1 0 0 0 0        x3  - x8          ..  - y8
    5  ¦ 0 0 0 1 1 0 0 0 0        x4  - xm          y8  - ym
```

5b) There are no free subareas
6a) The dimension of the matrix is reduced in the x-direction to a (4 x 9) matrix:

```
        y= 1 2 3 4 5 6 7 8 9          x                y

  x =_____      _____        _____
    1  ¦ 0 0 0 0 1 0 0 0 0        0   - x6          0   - y1
    2  ¦ 0 0 0 0 1 0 0 0 0        x1  - x7          y1  - y2
    3  ¦ 0 0 0 0 1 0 0 0 0        x2  - x8          y2  - ..
    4  ¦ 0 0 0 1 1 0 0 0 0        x3  - xm          ..  - y8
                                                    y8  - ym
```

6b) There are no free subareas.
7a) The dimension of the matrix is reduced in the x-direction to a (3 x 9) matrix:

```
        y= 1 2 3 4 5 6 7 8 9          x                y

  x =_____      _____        _____
    1  ¦ 0 0 0 0 1 0 0 0 0        0   - x7          0   - y1
    2  ¦ 0 0 0 0 1 0 0 0 0        x1  - x8          y1  - ..
    3  ¦ 0 0 0 0 1 0 0 0 0        x2  - xm          ..  - y8
                                                    y8  - ym
```

7b) There are no free subareas.
8a) The dimension of the matrix is reduced in the x-direction to a (2 x 9) matrix:

```
        y= 1 2 3 4 5 6 7 8 9          x                y

  x =_____      _____        _____
    1  ¦ 0 0 0 0 1 0 0 0 0        0   - x8          0   - ..
    2  ¦ 0 0 0 0 1 0 0 0 0        x1  - xm          ..  - ym
```

8b) There are no free subareas.
9a) The dimension of the matrix is reduced in the x-direction to a (1 x 9) matrix:

```
       y= 1 2 3 4 5 6 7 8 9        x              y
    x =_____       _____        _____
    1  | 0 0 0 0 1 0 0 0 0       0  - xm         0  - ..
                                                .. - ym
```

9b) There is one free subarea:

$$(0,y4) - (xm,y5) \tag{1}$$

10a) The dimension of the matrix is now reduced in the y-direction to a (9 x 8) matrix in accordance with the procedure given above:

```
       y= 1 2 3 4 5 6 7 8          x              y
    x =_____         _____        _____
    1  | 0 0 0 0 1 1 0 0         0  - x1         0  - y2
    2  | 1 0 0 0 1 1 0 0         x1 - x2         y1 - y3
    3  | 1 0 0 0 1 1 1 1         x2 - x3         y2 - y4
    4  | 1 1 1 1 1 1 1 1         x3 - x4         y3 - y5
    5  | 1 1 1 1 1 0 0 0         x4 - x5         y4 - y6
    6  | 0 0 0 1 0 0 0 0         x5 - x6         y5 - y7
    7  | 0 0 0 1 1 1 1 0         x6 - x7         y6 - y8
    8  | 0 1 1 1 1 1 1 0         x7 - x8         y7 - ym
    9  | 0 1 1 1 1 1 0 0         x8 - xm
```

10b) There are no free subareas.
11a) The dimension of the matrix is reduced in the x-direction to an (8 x 8) matrix:

```
       y= 1 2 3 4 5 6 7 8          x              y
    x =_____         _____        _____
    1  | 0 0 0 0 1 1 0 0         0  - x2         0  - y2
    2  | 1 0 0 0 1 1 0 0         x1 - x3         y1 - y3
    3  | 1 0 0 0 1 1 1 1         x2 - x4         y2 - y4
    4  | 1 1 1 1 1 0 0 0         x3 - x5         y3 - y5
    5  | 0 0 0 1 0 0 0 0         x4 - x6         y4 - y6
    6  | 0 0 0 1 0 0 0 0         x5 - x7         y5 - y7
    7  | 0 0 0 1 1 1 1 0         x6 - x8         y6 - y8
    8  | 0 1 1 1 1 1 0 0         x7 - xm         y7 - ym
```

11b) There are no free subareas.
12a) The dimension of the matrix is reduced in the x-direction to a (7 x 8) matrix:

```
      y= 1 2 3 4 5 6 7 8            x              y
  x =_____     _____     _____
      1  | 0 0 0 0 1 1 0 0         0   - x3        0   - y2
      2  | 1 0 0 0 1 1 0 0         x1  - x4        y1  - ..
      3  | 1 0 0 0 1 0 0 0         x2  - x5        ..  - ..
      4  | 0 0 0 1 0 0 0 0         x3  - x6        ..  - y8
      5  | 0 0 0 1 0 0 0 0         x4  - x7        y7  - ym
      6  | 0 0 0 1 0 0 0 0         x5  - x8
      7  | 0 0 0 1 1 1 0 0         x6  - xm
```

12b) There are no free subareas.

13a) The dimension of the matrix is reduced in the x-direction to a (6 x 8) matrix:

```
      y= 1 2 3 4 5 6 7 8            x              y
  x =_____     _____     _____
      1  | 0 0 0 0 1 1 0 0         0   - x4        0   - y2
      2  | 1 0 0 0 1 0 0 0         x1  - x5        y1  - ..
      3  | 0 0 0 0 0 0 0 0         x2  - x6        ..  - ..
      4  | 0 0 0 1 0 0 0 0         x3  - x7        ..  - y8
      5  | 0 0 0 1 0 0 0 0         x4  - x8        y7  - ym
      6  | 0 0 0 1 0 0 0 0         x5  - xm
```

13b) There is one free subarea:

$$(x1,0) - (x5,y2) \qquad [2]$$

14a) The dimension of the matrix is reduced in the x-direction to a (5 x 8) matrix:

```
      y= 1 2 3 4 5 6 7 8            x              y
  x =_____     _____     _____
      1  | 0 0 0 0 1 0 0 0         0   - x5        0   - y2
      2  | 0 0 0 0 0 0 0 0         x1  - x6        y1  - ..
      3  | 0 0 0 0 0 0 0 0         x2  - x7        ..  - ..
      4  | 0 0 0 1 0 0 0 0         x3  - x8        ..  - y8
      5  | 0 0 0 1 0 0 0 0         x4  - xm        y7  - ym
```

14b) There is one free subarea:

$$(0,y4) - (x5,y6) \qquad [3]$$

15a) The dimension of the matrix is reduced in the x-direction to a (4 x 8) matrix:

```
     y= 1 2 3 4 5 6 7 8          x                y
  x =_____    _____       _____
     1 ¦ 0 0 0 0 0 0 0 0        0   - x6         0   - y2
     2 ¦ 0 0 0 0 0 0 0 0        x1  - x7         y1  - ..
     3 ¦ 0 0 0 0 0 0 0 0        x2  - x8         ..  - ..
     4 ¦ 0 0 0 1 0 0 0 0        x3  - xm         ..  - y8
                                                 y7  - ym
```

15b) There is one free subarea:

$$(x3,y3) - (xm,y5) \hspace{3cm} [4]$$

16a) The dimension of the matrix is reduced in the x-direction to a (3 x 8) matrix:

```
     y= 1 2 3 4 5 6 7 8          x                y
  x =_____    _____       _____
     1 ¦ 0 0 0 0 0 0 0 0        0   - x7         0   - y2
     2 ¦ 0 0 0 0 0 0 0 0        x1  - x8         y1  - ..
     3 ¦ 0 0 0 0 0 0 0 0        x2  - xm         ..  - ..
                                                 y7  - ym
```

16b) There are no free subareas.

17a) There is no point in further reducing the x-direction because the matrix has become zero. The matrix from 10) is now reduced in the y-direction to a (9 x 7) matrix:

```
     y= 1 2 3 4 5 6 7            x                y
  x =_____      _____       _____
     1 ¦ 0 0 0 0 1 0 0          0   - x1         0   - y3
     2 ¦ 0 0 0 0 1 0 0          x1  - x2         y1  - y4
     3 ¦ 0 0 0 0 1 1 1          x2  - x3         y2  - y5
     4 ¦ 1 1 1 1 1 1 1          x3  - x4         y3  - y6
     5 ¦ 1 1 1 1 0 0 0          x4  - x5         y4  - y7
     6 ¦ 0 0 0 0 0 0 0          x5  - x6         y5  - y8
     7 ¦ 0 0 0 1 1 1 0          x6  - x7         y6  - ym
     8 ¦ 0 1 1 1 1 1 0          x7  - x8
     9 ¦ 0 1 1 1 1 0 0          x8  - xm
```

17b) There are no free subareas.

18a) The dimension of the matrix is reduced in the x-direction to an (8 x 7) matrix:

```
      y= 1 2 3 4 5 6 7          x                y

  x =_____      _____       _____
      1 ¦ 0 0 0 0 1 0 0         0   - x2          0   - y3
      2 ¦ 0 0 0 0 1 0 0         x1  - x3          y1  - y4
      3 ¦ 0 0 0 0 1 1 1         x2  - x4          y2  - y5
      4 ¦ 1 1 1 1 0 0 0         x3  - x5          y3  - y6
      5 ¦ 0 0 0 0 0 0 0         x4  - x6          y4  - y7
      6 ¦ 0 0 0 0 0 0 0         x5  - x7          y5  - y8
      7 ¦ 0 0 0 1 1 1 0         x6  - x8          y6  - ym
      8 ¦ 0 1 1 1 1 0 0         x7  - xm
```

18b) There are no free subareas.

19a) The dimension of the matrix is reduced in the x-direction to a (7 x 7) matrix:

```
      y= 1 2 3 4 5 6 7          x                y

  x =_____      _____       _____
      1 ¦ 0 0 0 0 1 0 0         0   - x3          0   - y3
      2 ¦ 0 0 0 0 1 0 0         x1  - x4          y1  - y4
      3 ¦ 0 0 0 0 0 0 0         x2  - x5          y2  - y5
      4 ¦ 0 0 0 0 0 0 0         x3  - x6          y3  - y6
      5 ¦ 0 0 0 0 0 0 0         x4  - x7          y4  - y7
      6 ¦ 0 0 0 0 0 0 0         x5  - x8          y5  - y8
      7 ¦ 0 0 0 1 1 0 0         x6  - xm          y6  - ym
```

19b) There are no free subareas.

20a) The dimension of the matrix is reduced in the x-direction to a (6 x 7) matrix:

```
      y= 1 2 3 4 5 6 7          x                y

  x =_____      _____       _____
      1 ¦ 0 0 0 0 1 0 0         0   - x4          0   - y3
      2 ¦ 0 0 0 0 0 0 0         x1  - x5          y1  - y4
      3 ¦ 0 0 0 0 0 0 0         x2  - x6          y2  - y5
      4 ¦ 0 0 0 0 0 0 0         x3  - x7          y3  - y6
      5 ¦ 0 0 0 0 0 0 0         x4  - x8          y4  - y7
      6 ¦ 0 0 0 0 0 0 0         x5  - xm          y5  - y8
                                                 y6  - ym
```

20b) There is one free subarea:

$$(0,y4) - (x4,y7) \hspace{4cm} [5]$$

21a) The dimension of the matrix is reduced in the x-direction to a (5 x 7) matrix:

```
      y= 1 2 3 4 5 6 7           x              y
  x =_____          _____        _____
      1  ¦ 0 0 0 0 0 0 0         0   - x5        0   - y3
      2  ¦ 0 0 0 0 0 0 0        x1  - x6        y1  - y4
      3  ¦ 0 0 0 0 0 0 0        x2  - x7        y2  - y5
      4  ¦ 0 0 0 0 0 0 0        x3  - x8        y3  - y6
      5  ¦ 0 0 0 0 0 0 0        x4  - xm        y4  - y7
                                               y5  - y8
                                               y6  - ym
```

21b) There are no free subareas.

22a) There is no point in reducing in the x-direction because the matrix is zero. The matrix from 17) is now reduced in the y-direction to a (9 x 6) matrix:

```
      y= 1 2 3 4 5 6             x              y
  x =_____            _____        _____
      1  ¦ 0 0 0 0 0 0          0   - x1        0   - y4
      2  ¦ 0 0 0 0 0 0         x1  - x2        y1  - y5
      3  ¦ 0 0 0 0 1 1         x2  - x3        y2  - y6
      4  ¦ 1 1 1 1 1 1         x3  - x4        y3  - y7
      5  ¦ 1 1 1 0 0 0         x4  - x5        y4  - y8
      6  ¦ 0 0 0 1 1 0         x6  - x7        y5  - ym
      8  ¦ 0 1 1 1 1 0         x7  - x8
      9  ¦ 0 1 1 1 0 0         x8  - xm
```

22b) There are no free subareas.

23a) The dimension of the matrix is reduced in the x-direction to an (8 x 6) matrix:

```
        y= 1 2 3 4 5 6              x                 y
    x =_____         _____         _____
      1   ¦ 0 0 0 0 0 0          0   - x2          0   - y4
      2   ¦ 0 0 0 0 0 0          x1  - x3          y1  - y5
      3   ¦ 0 0 0 0 1 1          x2  - x4          y2  - y6
      4   ¦ 1 1 1 0 0 0          x3  - x5          y3  - y7
      5   ¦ 0 0 0 0 0 0          x4  - x6          y4  - y8
      6   ¦ 0 0 0 0 0 0          x5  - x7          y5  - ym
      7   ¦ 0 0 0 1 1 0          x6  - x8
      8   ¦ 0 1 1 1 0 0          x7  - xm
```

23b) There are no free subareas.

24a) The dimension of the matrix is reduced in the x-direction to a (7 x 6) matrix:

```
        y= 1 2 3 4 5 6              x                 y
    x =_____         _____         _____
      1   ¦ 0 0 0 0 0 0          0   - x3          0   - y4
      2   ¦ 0 0 0 0 0 0          x1  - x4          y1  - y5
      3   ¦ 0 0 0 0 0 0          x2  - x5          y2  - y6
      4   ¦ 0 0 0 0 0 0          x3  - x6          y3  - y7
      5   ¦ 0 0 0 0 0 0          x4  - x7          y4  - y8
      6   ¦ 0 0 0 0 0 0          x5  - x8          y5  - ym
      7   ¦ 0 0 0 1 0 0          x6  - xm
```

24b) There is one free subarea:

$$(x6,y3) - (xm,y7) \hspace{4cm} [6]$$

25a) The dimension of the matrix is reduced in the x-direction to a (6 x 6) matrix:

```
        y= 1 2 3 4 5 6              x                 y
    x =_____         _____         _____
      1   ¦ 0 0 0 0 0 0          0   - x4          0   - y4
      2   ¦ 0 0 0 0 0 0          x1  - x5          y1  - y5
      3   ¦ 0 0 0 0 0 0          x2  - x6          y2  - y6
      4   ¦ 0 0 0 0 0 0          x3  - x7          y3  - y7
      5   ¦ 0 0 0 0 0 0          x4  - x8          y4  - y8
      6   ¦ 0 0 0 0 0 0          x5  - xm          y5  - ym
```

25b) There are no free subareas.

26a) There is no point in reducing in the x-direction because the matrix is zero. The matrix from 22) is now reduced in the y-direction to a (9 x 5) matrix:

```
        y= 1 2 3 4 5              x                y
  x  =_____      _____       _____
     1  ¦ 0 0 0 0 0          0   - x1          0   - y5
     2  ¦ 0 0 0 0 0          x1  - x2          y1  - y6
     3  ¦ 0 0 0 0 1          x2  - x3          y2  - y7
     4  ¦ 1 1 1 1 1          x3  - x4          y3  - y8
     5  ¦ 1 1 0 0 0          x4  - x5          y4  - ym
     6  ¦ 0 0 0 0 0          x5  - x6
     7  ¦ 0 0 0 1 0          x6  - x7
     8  ¦ 0 1 1 1 0          x7  - x8
     9  ¦ 0 1 1 0 0          x8  - xm
```

26b) There are no free subareas.

27a) The dimension of the matrix is reduced in the x-direction to a (8 x 5) matrix:

```
        y= 1 2 3 4 5              x                y
  x  =_____      _____       _____
     1  ¦ 0 0 0 0 0          0   - x2          0   - y5
     2  ¦ 0 0 0 0 0          x1  - x3          y1  - y6
     3  ¦ 0 0 0 0 1          x2  - x4          y2  - y7
     4  ¦ 1 1 0 0 0          x3  - x5          y3  - y8
     5  ¦ 0 0 0 0 0          x4  - x6          y4  - ym
     6  ¦ 0 0 0 0 0          x5  - x7
     7  ¦ 0 0 0 1 0          x6  - x8
     8  ¦ 0 1 1 0 0          x7  - xm
```

27b) There are two free subareas:

$$(x2, y4) - (x4, ym) \qquad\qquad [7]$$

$$(x6, y3) - (x8, y8) \qquad\qquad [8]$$

28a) The dimension of the matrix is reduced in the x-direction to a (7 x 5) matrix:

```
      y= 1 2 3 4 5                    x                  y

   x =_____              _____          _____

     1  ¦  0 0 0 0 0               0   - x3           0   - y5

     2  ¦  0 0 0 0 0              x1 - x4            y1 - y6

     3  ¦  0 0 0 0 0              x2 - x5            y2 - y7

     4  ¦  0 0 0 0 0              x3 - x6            y3 - y8

     5  ¦  0 0 0 0 0              x4 - x7            y4 - ym

     6  ¦  0 0 0 0 0            .  x5 - x8

     7  ¦  0 0 0 0 0              x6 - xm
```

28b) There are no free subareas.

29a) There is no point in reducing in the x-direction because the matrix is zero. The matrix from 26) is now reduced in the y-direction to a (9 x 4) matrix:

```
      y= 1 2 3 4                      x                  y

   x =_____               _____          _____

     1  ¦  0 0 0 0               0   - x1           0   - y6

     2  ¦  0 0 0 0              x1 - x2            y1 - y7

     3  ¦  0 0 0 0              x2 - x3            y2 - y8

     4  ¦  1 1 1 1              x3 - x4            y3 - ym

     5  ¦  1 0 0 0              x4 - x5

     6  ¦  0 0 0 0              x5 - x6

     7  ¦  0 0 0 0              x6 - x7

     8  ¦  0 1 1 0              x7 - x8

     9  ¦  0 1 0 0              x8 - xm
```

29b) There are no free subareas.

30a) The dimension of the matrix is reduced in the x-direction to an (8 x 4) matrix:

```
        y= 1 2 3 4                    x                y
    x =_____               _____         _____
      1  ¦  0 0 0 0                 0   - x2          0   - y6
      2  ¦  0 0 0 0                 x1 - x3          y1 - y7
      3  ¦  0 0 0 0                 x2 - x4          y2 - y8
      4  ¦  1 0 0 0                 x3 - x5          y3 - ym
      5  ¦  0 0 0 0                 x4 - x6
      6  ¦  0 0 0 0                 x5 - x7
      7  ¦  0 0 0 0                 x6 - x8
      8  ¦  0 1 0 0                 x7 - xm
```

30b) There are two free subareas:

$$(x3,0) - (x5,y6) \qquad\qquad [9]$$

$$(x7,y1) - (xm,y7) \qquad\qquad [10]$$

31a) The dimension of the matrix is reduced in the x-direction to a (7 x 4) matrix:

```
        y= 1 2 3 4                    x                y
    x =_____               _____         _____
      1  ¦  0 0 0 0                 0   - x3          0   - y6
      2  ¦  0 0 0 0                 x1 - x4          y1 - y7
      3  ¦  0 0 0 0                 x2 - x5          y2 - y8
      4  ¦  0 0 0 0                 x3 - x6          y3 - ym
      5  ¦  0 0 0 0                 x4 - x7
      6  ¦  0 0 0 0                 x5 - x8
      7  ¦  0 0 0 0                 x6 - xm
```

31b) There are no free subareas.
32a) There is no point in reducing in the x-direction because the matrix is zero. The matrix from 29) is now reduced in the y-direction to a (9 x 2) matrix:

```
        y= 1 2 3                    x              y
    x =_____                  _____      _____
    1  | 0 0 0                   0   - x1       0   - y7
    2  | 0 0 0                   x1  - x2       y1  - y8
    3  | 0 0 0                   x2  - x3       y2  - ym
    4  | 1 1 1                   x3  - x4
    5  | 0 0 0                   x4  - x5
    6  | 0 0 0                   x5  - x6
    7  | 0 0 0                   x6  - x7
    8  | 0 1 0                   x7  - x8
    9  | 0 0 0                   x8  - xm
```

32b) There is one free subarea:

$$(x7, y1) - (x8, y8) \qquad\qquad [11]$$

33a) The dimension of the matrix is now reduced in the x-direction to an (8 x 3) matrix:

```
        y= 1 2 3                    x              y
    x =_____                  _____      _____
    1  | 0 0 0                   0   - x2       0   - y7
    2  | 0 0 0                   x1  - x3       y1  - y8
    3  | 0 0 0                   x2  - x4       y2  - ym
    4  | 0 0 0                   x3  - x5
    5  | 0 0 0                   x4  - x6
    6  | 0 0 0                   x5  - x7
    7  | 0 0 0                   x6  - x8
    8  | 0 0 0                   x7  - xm
```

33b) There are no free subareas.
34a) There is no point in reducing in the x-direction because the matrix is zero. The matrix from 32) is now reduced in the y-direction to a (9 x 2) matrix:

```
        y= 1  2                    x                 y
    x =_____                _____         _____
    1  │  0  0                 0   - x1          0   - y8
    2  │  0  0                 x1  - x2          y1  - ym
    3  │  0  0                 x2  - x3
    4  │  1  1                 x3  - x4
    5  │  0  0                 x4  - x5
    6  │  0  0                 x5  - x6
    7  │  0  0                 x6  - x7
    8  │  0  0                 x7  - x8
    9  │  0  0                 x8  - xm
```

34b) There are no free subareas.

35a) The dimension of the matrix is reduced in the x-direction to an (8 x 2) matrix:

```
        y= 1  2                    x                 y
    x =_____                _____         _____
    1  │  0  0                 0   - x2          0   - y8
    2  │  0  0                 x1  - x3          y1  - ym
    3  │  0  0                 x2  - x4
    4  │  0  0                 x3  - x5
    5  │  0  0                 x4  - x6
    6  │  0  0                 x5  - x7
    7  │  0  0                 x6  - x8
    8  │  0  0                 x7  - xm
```

35b) There are no free subareas.

36a) There is no point in further reducing in the x-direction because the matrix is zero. The matrix from 34) is reduced in the y-direction to an (9 x 1) matrix:

```
      y= 1                        x              y
  x =____                     _____    _____
    1  ¦  0                   0   -  x1      0   -  ym
    2  ¦  0                   x1  -  x2
    3  ¦  0                   x2  -  x3
    4  ¦  1                   x3  -  x4
    5  ¦  0                   x4  -  x5
    6  ¦  0                   x5  -  x6
    7  ¦  0                   x6  -  x7
    8  ¦  0                   x7  -  x8
    9  ¦  0                   x8  -  xm
```

36b) There is one free subarea:

$$(x3, 0) - (x4, ym) \hspace{3cm} [12]$$

37a) The dimension of the matrix is reduced in the x-direction to an (8 x 1) matrix:

```
      y= 1                        x              y
  x =____                     _____    _____
    1  ¦  0                   0   -  x2      0   -  ym
    2  ¦  0                   x1  -  x3
    3  ¦  0                   x2  -  x4
    4  ¦  0                   x3  -  x5
    5  ¦  0                   x4  -  x6
    6  ¦  0                   x6  -  x8
    8  ¦  0                   x7  -  xm
```

37b) There is no free subarea.

38a) There is no point in further reducing in the x-direction. 36) cannot be reduced further in the y-direction either. The matrix reduction has therefore been completed.

Of the maximum of 9 x 9 = 81 possible reduction steps, only 39 have been necessary in order to find all the free subareas.

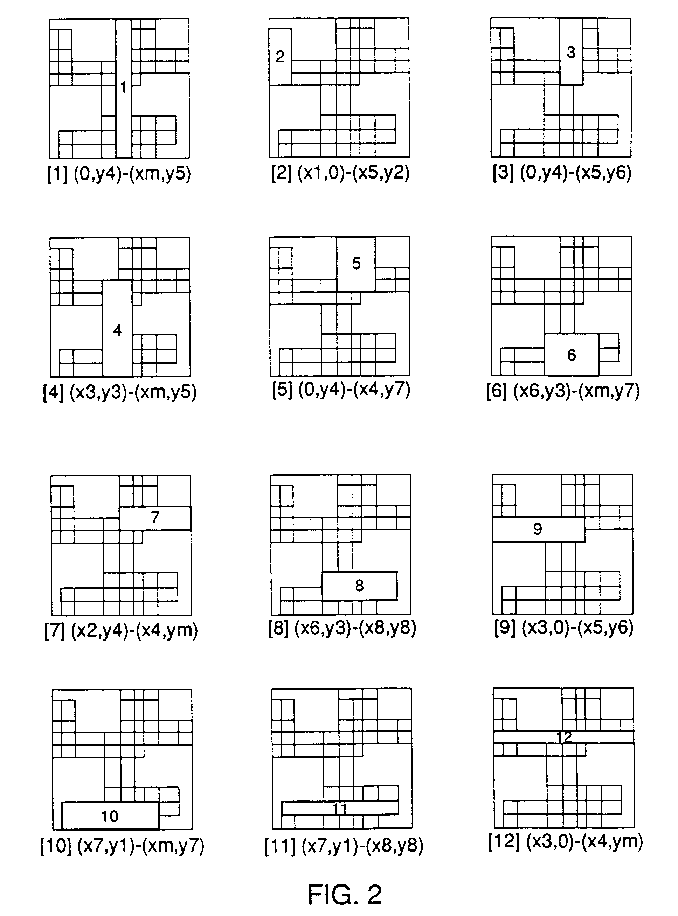

By means of the matrix reduction and by reading of the continuously adjusted dimension tables, a total of 12 free subareas have been found and these are reproduced again below. The position of the free subareas found in the matrix is shown in Figure 2.

| [1] | (0,y4)-(xm,y5) | [2] | (x1,0)-(x5,y2) |
|-----|----------------|------|----------------|
| [3] | (0,y4)-(x5,y6) | [4] | (x3,y3)-(xm,y5) |
| [5] | (0,y4)-(x4,y7) | [6] | (x6,y3)-(xm,y7) |
| [7] | (x2,y4)-(x4,ym) | [8] | (x6,y3)-(x8,y8) |
| [9] | (x3,0)-(x5,y6) | [10] | (x7,y1)-(xm,y7) |

(continued)

| [11] | (x7,y1)-(x8,y8) | [12] | (x3,0)-(x4,ym) |
|---|---|---|---|

The free spaces in a three-dimensional space having the shape of a right parallelepiped can also be determined in an analogous manner. If the third dimension, for example the height of the space to be filled, is termed z, a three-dimensional matrix having $z = z1, z2, ....zm$ has to be determined. By analogy with the principle described above for the two-dimensional case, there is a free space at the position $(x_l, y_l, z_l)$ in the space if:

$(x_l,y_l,z_l) = 1$ and $(x_{l-1},y_l,z_l) = 0$ and $(x_{l+1},y_l,z_l) = 0$ and $(x_l,y_{l-1},z_l) = 0$ and $(x_l,y_{l+1},z_l) = 0$ and $(x_l,y_l,z_{l-1}) = 0$ and $(x_l,y_l,z_{l+1})$ $= 0$. (IV)

By reducing the matrix in the x-, y- or z-direction, (IV) can now be used to search for larger spaces again, the dimensions of said spaces again being determined in the same way as in the two-dimensional case by the number of times that a reduction is carried out in the x-direction and/or the y-direction and/or the z-direction, respectively.

Analogously to the two-dimensional case, the matrix is reduced in the x-direction by determining for each element $(x_l, y_l, z_l)$ of the matrix whether:

$(x_l, y_l, z_l) = 1$ and $(x_{l+1}, y_l z_l) = 1$ (V), in which case $(x_l, y_l, z_l)' := 1$ and if (V) is not satisfied, $(x_l, y_l, z_l)' = 0$.

The reduction in the y-direction determines whether:

$(x_l, y_l, z_l) = 1$ and $(x_l, y_{l+1}, z_l) = 1$ (VI), in which case $(x_l, y_l, z_l)' := 1$, and if (VI) is not satisfied, $(x_l, y_l, z_l)' = 0$.

Finally, the reduction in the z-direction determines whether:

$(x_l, y_l, z_l) = 1$ and $(x_l, y_l, z_{l+1}) = 1$ (VII), in which case $(x_l, y_l, z_l)' := 1$, and if (VII) is not satisfied, $(x_l, y_l, z_l)' = 0$.

To determine the exact position of the free spaces found using (IV), dimension tables are also updated in the three-dimensional case for the x-, y- and z-direction and these are adjusted during reduction of the matrices in the x-, y- and z-direction, respectively.

A three-dimensional matrix is reduced in accordance with the procedure below:

$$(X,Y,Z)$$

$$\overline{\phantom{xxxxxxxxxxxxxxxxxxxxxxxxxxxxxxxxxxxxxxxxxxxxx}}$$

$$(X-1,Y,Z) \qquad (X,Y-1,Z) \qquad (X,Y,Z-1)$$

$$(X-2,Y,Z) \qquad (X,Y-2,Z) \qquad (X-1,Y,Z-1) \qquad (X,Y,Z-2)$$

$$(X-1,Y-1,Z) \qquad\qquad (X,Y-1,Z-1)$$

$$\cdots\cdots\cdots\cdots\cdots\cdots\cdots\cdots\cdots\cdots\cdots\cdots\cdots\cdots\cdots\cdots\cdots\cdots$$

$$\cdots\cdots\cdots\cdots\cdots\cdots\cdots\cdots\cdots\cdots\cdots\cdots\cdots\cdots\cdots\cdots\cdots$$

$$(1,1,2) \qquad\qquad (1,2,1) \qquad\qquad (2,1,1)$$

$$\overline{\phantom{xxxxxxxxxxxxxxxxxxxxxxxxxxxxxxxxxxxxxx}}$$

$$(1,1,1)$$

Starting from the second "layer" in this procedure, a reduced matrix can be obtained via various routes, it being possible in principle to find free spaces via the various routes, but it being certain that all the existing free spaces are found if the entire reduction is carried out until either the (1, 1, 1) matrix is reached or the last reduced matrix in each dimension is a null matrix.

After positioning an object in one of the free spaces found, the matrix has to be adjusted to the new situation, after which free spaces can be sought for a subsequent object. The matrix is adjusted as follows: When a package is positioned in a free space found, account has to be taken in each of the dimensions in the new situation of not more than two new coordinates which indicate the boundaries of the package positioned. These coordinates are $x_a$, $y_a$, $z_a$ and $x_b$, $y_b$, $z_b$; at least some of the new coordinates correspond to coordinates which were already included in one of the dimension tables because a new object never ends up freely suspended in the space, but always against one or more of the walls of the space to be filled and/or against the sides of adjacent, already positioned objects. On the basis of the available dimension table of the original matrix, it is possible to determine where the coordinates of the freshly positioned object should be positioned in the tables. Because the new coordinates have been inserted in the relevant position in the dimension table, the matrix increases by not more than two elements in each dimension. The matrix representation can be immediately adjusted in this way after positioning a new object in said representation, with the result that the complete representation does not have to be continuously recalculated. The complexity of the calculation work necessary increases as the dimensions of the matrix increase, but this effect is at least partly nullified by the following two factors. Firstly, free spaces having dimensions which are smaller than predetermined minimum dimensions are deleted from the matrix and the tables, for example because it is known that no objects having smaller dimensions than said minimum dimensions are available, and secondly, during the loading of the space by positioning an object, adjacent layers often become equal to one another and in that case the two layers can be replaced by one of said layers, with the result that the matrix representation and therefore also the associated dimension tables are simplified. In this way, the increase in the complexity of the matrix and therefore the increase in the calculation work necessary as a consequence of positioning new packages can be compensated for at least partly.

**Claims**

1. Method of determining free subareas on an area partially covered with essentially rectangular objects, wherein an essentially rectangular area to be covered having dimensions X and Y is depicted in the form of a two-dimensional matrix $(x, y)$ having x rows and y columns, each element of the matrix representing a rectangle on the area and it being established for each element whether the corresponding rectangle in the area is free or occupied, the corresponding element of the matrix being assigned a first logic value (A) in the first mentioned case and a second logic value (B) in the case mentioned second, there being a free subarea on the area if $(x_l, y_l) = B$ and $(x_{l-1}, y_l) = A$ and $(x_l, y_{l-1}) = A$ and $(x_{l+1}, y_l) = A$ $(x_l, y_{l+1}) = A$ (I) for the corresponding element in the matrix; a matrix reduction being carried out, after determining the elements $x_l$, $y_l$ which satisfy (I), by always reducing by one the number of rows or the number of columns in the matrix in a predetermined sequence in consecutive steps until a (1, 1) matrix or a null matrix is left, the possible free subareas always being determined after a reduction step with the aid of (I); the number of rows being reduced by deriving one row from predetermined rows L, L+1 by determining, for each element $(x_l, y_l)$ of each row, whether $(x_l, y_l) = B$ and $(x_{l+1}, y_l) = B$ (II), in which case the element $(x_l, y_l)': = B$ in the reduced matrix $(x, y)'$, and if (II) is not satisfied, the element $(x_l, y_l)': = A$; the number of columns being reduced by deriving one column from predetermined columns L, L+1 by determining, for each element $(x, y)$ of each column, whether $(x_l, y_l) = B$ and $(x_l, y_{l+1}) = B$ (III), in which case the element $(x_l, y_l)': = B$ in the reduced matrix $(x, y)'$, and if (III) is not satisfied, the element $(x_l, y_l)': = A$; the dimensions of the free subareas determined using (I) being determined by creating a dimension table both for the rows and for the columns of the matrix, and by adjusting the dimension table for the rows or for the columns in a corresponding step during the matrix reduction to sum the dimensions of the rows or columns l, l+1.

2. Method of determining free spaces in a space partially filled with objects essentially having the form of a right parallelepiped, wherein a space essentially having the form of a right parallelepiped and having dimensions X, Y and Z is depicted in the form of three-dimensional matrix $(x, y, z)$ having x rows, y columns and z layers, each element of the matrix representing a right parallelepiped in the space and it being established for each element whether the corresponding right parallelepiped in the space is free or occupied, the corresponding element of the associated matrix being assigned a first logic value (A) in the first mentioned case and a second logic value (B) in the case mentioned second, there being a free space in the space if $(x_l, y_l, z_l) = B$ and $(x_{l-1}, y_l, z_l) = A$ and $(x_l, y_{l-1}, z_l) = A$ and $(x_{l+1}, y_l, z_l) = A$ and $(x_l, y_{l+1}, z_l) = A$ and $(x_l, y_l, z_{l-1}) = A$ and $(x_l, y_l, z_{l+1}) = A$ (IV) for the corresponding element in the matrix; a matrix reduction being carried out, after determining the elements $(x_l, y_l, z_l)$ which satisfy (IV), by reducing by one the number of rows or the number of columns or the number of layers of the matrix in a predetermined sequence in consecutive steps until a (1,1,1) matrix or a null matrix is left, the possible free spaces always being determined after a reduction step with the aid of (IV); the number of rows being reduced by deriving one row from predetermined rows L, l+1 by determining, for each element $(x_l, y_l, z_l)$ of the matrix, whether $(x_l, y_l, z_l) = B$ and $(x_{l+1}, y_l, z_l) = B$ (V), in which case the element $(x_l, y_l, z_l)': = B$ in the reduced matrix $(x, y, z)'$, and if (V) is not satisfied, the element $(x_l, y_l, z_l)' = A$; the number of columns being reduced by deriving one column from predetermined columns L, l+1 by determining whether $(x_l, y_l, z_l) = B$ and $(x_l, y_{l+1}, z_l) = B$ (VI), in which case the element $(x_l, y_l, z_l)': = B$ in the reduced matrix $(x, y, z)'$, and if (VI) is not satisfied, the element $(x_l, y_l, z_l)' = A$; the number of layers being reduced by deriving one layer from predetermined layers L, L+1 by determining whether $(x_l, y_l, z_l) = B$ and $(x_l, y_l, z_{l+1}) = B$ (VII), in which case the element $(x_l, y_l, z_l)': = B$ in the reduced matrix $(x, y, z)'$, and if (VII) is not satisfied, the element $(x_l, y_l, z_l)' = A$; the dimensions of the free spaces determined using (IV) being found by creating a dimension table for the rows and for the columns and for the layers of the matrix, and by adjusting the dimension table for the rows or the columns or the layers in a corresponding step during the matrix reduction to sum the dimensions of the rows, columns or layers l, l+1.

**Patentansprüche**

1. Verfahren zur Bestimmung von freien Teilbereichen von einem teilweise mit Objekten in Gestalt von Rechtecken bedeckten Bereich, bei welchem Verfahren ein im wesentlichen rechteckiger abzudeckender Bereich, der die Dimensionen X und Y aufweist, in Gestalt einer zweidimensionalen Matrix (x, y) dargestellt wird, die x Zeilen und y Spalten umfasst, wobei jedes Element der Matrix ein Rechteck auf dem Bereich darstellt und für jedes Element festgestellt wird, ob das entsprechende Rechteck in dem Bereich frei oder besetzt ist, wobei dem zugehörigen Element der Matrix ein erster logischer Wert (A) im zuerst genannten Fall und ein zweiter logischer Wert (B) im als zweites genannten Fall zugewiesen wird, wobei ein freier Teilbereich auf dem Bereich vorliegt, falls $(x_I,y_I) = B$ und $(x_{I-1},y_I) = A$ und $(x_I,y_{I-1}) = A$ und $(x_{I+1},y_I) = A$ und $(x_1,y_{I+1}) = A$ (I) für das zugehörige Element in der Matrix ist; dass eine Matrixreduktion durchgeführt wird, nachdem die Elemente $(x_I,y_I)$ festgestellt worden sind, die (I) erfüllen, indem jeweils um eins die Anzahl der Zeilen oder die Anzahl der Spalten in der Matrix in einer vorbestimmten Abfolge in aufeinanderfolgenden Schritten reduziert wird, bis eine (1,1)-Matrix oder eine Null-Matrix übrigbleibt, wobei die möglichen freien Teilbereiche immer nach einem Reduktionsschritt mit der Hilfe von (I) bestimmt werden; dass die Anzahl der Zeilen durch Ableiten einer Zeile aus vorbestimmten Zeilen 1, I+1 vermindert wird, indem für jedes Element $(x_I,y_I)$ jeder Zeile bestimmt wird, ob $(x_I,y_I) = B$ und $(x_{I+1},y_I) = B$ (II), in welchem Fall das Element $(x_I, y_I)' := B$ in der reduzierten Matrix (x, y)' gesetzt wird, und dass, falls (II) nicht erfüllt wird, das Element $(x_I,y_I)' := A$ gesetzt wird, dass die Anzahl von Spalten durch Ableiten einer Spalte aus vorbestimmten Spalten 1, I+1 vermindert wird, indem für jedes Element $(x_I,y_I)$ jeder Spalte bestimmt wird, ob $(x_I,y_I) = B$ und $(x_I,y_{I+1}) = B$ (III), in welchem Fall das Element $(x_I,y_I)' := B$ in der reduzierten Matrix (x, y)' gesetzt wird, und dass, falls (III) nicht erfüllt wird, das Element $(x_I,y_I)' := A$ gesetzt wird, dass die Dimensionen der freien Teilbereiche, die unter Einsatz von (I) bestimmt worden sind, bestimmt werden, indem eine Dimensionstabelle sowohl für die Zeilen als auch für die Spalten der Matrix erzeugt wird und durch Einstellen der Dimensionstabelle für die Zeilen oder für die Spalten in einem zugehörigen Schritt während der Matrixreduktion, um die Dimensionen der Zeilen oder Spalten 1, I+1 aufzusummieren.

2. Verfahren zur Bestimmung von freien Räumen in einem teilweise mit Objekten, die im wesentlichen die Gestalt eines Parallelepipeds mit rechten Winkeln aufweisen, gefüllten Raum, bei welchem Verfahren der zu füllende Raum, der im wesentlichen die Gestalt eines Parallelepipeds mit rechten Winkeln aufweist und der die Dimensionen X, Y und Z aufweist, die in Gestalt einer dreidimensionalen Matrix (x, y, z) dargestellt wird, die x Zeilen, y Spalten und z Schichten umfasst, wobei jedes Element der Matrix ein Parallelepiped mit rechten Winkeln in dem Raum darstellt und für jedes Element festgestellt wird, ob das zugehörige Parallelepiped mit rechten Winkeln in dem Raum frei oder besetzt ist, wobei dem zugehörigen Element der zugeordneten Matrix ein erster logischer Wert (A) in dem zuerst genannten Fall und ein zweiter logischer Wert (B) in dem als zweites genannten Fall zugewiesen wird, wobei ein freier Raum in dem Raum vorliegt, falls $(x_I, y_I, z_I) = B$ und $(x_{I-1}, y_I, z_I) = A$ und $(x_I, y_{I-1}, z_I) = A$ und $(x_{I+1},y_I,z_I) = A$ und $(x_I,y_{I+1},z_I) = A$ und $(x_I,y_I,z_{I-1}) = A$ und $(x_I,y_I,z_{I+1}) = A$ (IV) für das zugehörige Element in der Matrix ist, dass eine Matrixreduktion durchgeführt wird, nachdem die Elemente $(x_I,y_I,z_I)$ festgestellt worden sind, die (IV) erfüllen, indem um eins die Anzahl von Zeilen oder die Anzahl von Spalten oder die Anzahl von Schichten in der Matrix in einer vorbestimmten Abfolge in aufeinanderfolgenden Schritten reduziert wird, bis eine (1,1,1)-Matrix oder eine Null-Matrix übrigbleibt, wobei die möglichen freien Räume immer nach einem Reduktionsschritt jeweils mit der Hilfe von (IV) bestimmt werden; dass die Anzahl von Zeilen durch Ableiten einer Zeile aus den vorbestimmten Zeilen 1, I+1 vermindert wird, indem für jedes Element $(x_I,y_I,z_I)$ der Matrix festgestellt wird, ob $(x_I,y_I,z_I) = B$ und $(x_{I+1},y_I,z_I) = B$ (V), in welchem Falle das Element $(x_I,y_I,z_I)' := B$ in der reduzierten Matrix (x, y, z)' gesetzt wird, und dass, falls (V) nicht erfüllt wird, das Element $(x_I,y_I,z_I)' = A$ gesetzt wird; dass die Anzahl von Spalten durch Ableiten einer Spalte aus den vorbestimmten Spalten I, I+1 vermindert wird, indem festgestellt wird, ob $(x_I,y_I,z_I) = B$ und $(x_I,y_{I+1},z_I) = B$ (VI), in welchem Falle das Element $(x_I,y_I,z_I)' := B$ in der reduzierten Matrix (x, y, z)' gesetzt wird; und dass, falls (VI) nicht erfüllt ist, das Element $(x_I,y_I,z_I)' = A$ gesetzt wird; dass die Anzahl von Schichten durch Ableiten einer Schicht aus den vorbestimmten Schichten I, I+1 vermindert wird, indem festgestellt wird, ob $(x_I,y_I,z_I) = B$ und $(x_I,y_I,z_{I+1}) = B$ (VII), in welchem Falle das Element $(x_I,y_I,z_I)' := B$ in der reduzierten Matrix (x, y, z)' gesetzt wird; und dass, falls (VII) nicht erfüllt ist, das Element $(x_I,y_I,z_I)' = A$ gesetzt wird; dass die Dimensionen der freien Räume, die unter Einsatz von (IV) festgestellt worden sind, festgestellt werden, indem eine Dimensionstabelle für die Zeilen und für die Spalten und für die Schichten der Matrix erzeugt wird und durch Einstellen der Dimensionstabelle für die Zeilen oder die Spalten oder die Schichten in einem entsprechenden Schritt während der Matrixreduktion, um die Dimensionen der Zeilen, Spalten oder Schichten I, I+1 aufzusummieren.

**Revendications**

1. Procédé de détermination de surfaces libres sur une aire partiellement couverte d'objets sensiblement rectangulaires, dans lequel une aire sensiblement rectangulaire à couvrir, de dimensions X et Y, est représentée sous la forme d'une matrice bidimensionnelle (x, y) comportant x rangées et y colonnes, chaque élément de la matrice représentant un rectangle sur l'aire et étant précisé qu'il est établi pour chaque élément si le rectangle correspondant de l'aire est libre ou occupé, l'élément correspondant de la matrice prenant une première valeur logique (A) dans le premier cas mentionné et une seconde valeur logique (B) dans le second cas mentionné, étant précisé qu'il y a une surface libre sur l'aire si $(x_I, y_I)$ = B et $(x_{I-1}, y_I)$ = A et $(x_I, y_{I-1})$ = A et $(x_{I+1}, y_I)$ = A et $(x_I, y_{I+1})$ = A (I) pour l'élément correspondant de la matrice; une réduction de la matrice étant effectuée après que soient déterminés les éléments $x_I$, $y_I$ qui satisfont (I), en réduisant toujours de un le nombre de rangées ou le nombre de colonnes de la matrice selon une séquence prédéterminée, par pas consécutifs jusqu'à ce qu'il ne reste qu'une matrice (1, 1) ou une matrice nulle, les surfaces libres possibles étant toujours déterminées après un pas de réduction à l'aide de (I); le nombre de rangées étant réduit en retirant des rangées prédéterminées l,l+1 une rangée, en déterminant, pour chaque élément $(x_I, y_I)$ de chaque rangée, si, oui ou non, $(x_I, y_I)$ = B et $(x_{I+1}, y_I)$ = B (II), cas dans lequel l'élément $(x_I, y_I)'$: = B dans la matrice réduite (x, y)', et si (II) n'est pas satisfait l'élément $(x_I, y_I)'$: = A; le nombre de colonnes étant réduit en retirant des colonnes prédéterminées l,l+1 une colonne, en déterminant pour chaque élément (x, y) de chaque colonne, oui ou non, $(x_I, y_I)$ = B et $(x_I, y_{I+1})$ = B (III), cas dans lequel l'élément $(x_I, y_I)'$: = B dans la matrice réduite (x $y_I$)', et si (III) n'est pas satisfait l'élément $(x_I, y_I)'$: = A; les dimensions des surfaces libres déterminées à l'aide de (I) étant déterminées en créant une table de dimension à la fois pour les rangées et pour les colonnes de la matrice et en ajustant la table de dimension pour les rangées ou pour les colonnes en un pas correspondant au cours de la réduction de la matrice pour faire la somme des dimensions des rangées ou des colonnes l, l+1.

2. Procédé de détermination d'espaces libres dans un volume partiellement rempli d'objets ayant sensiblement la forme d'un parallélépipède rectangle, dans lequel un volume ayant sensiblement la forme d'un parallélépipède rectangle et de dimension X, Y et Z, est représenté sous la forme d'une matrice tridimensionnelle (x, y, z) comportant x rangées, y colonnes et z couches, chaque élément de la matrice représentant un parallélépipède rectangle dans le volume et étant précisé qu'il est établi pour chaque élément si oui ou non, le parallélépipède rectangle correspondant dans le volume est libre ou occupé, l'élément correspondant de la matrice associée prenant une valeur logique (A) dans le premier cas mentionné et une seconde valeur logique (B) dans le second cas mentionné, étant précisé qu'il existe un espace libre dans le volume si $(x_I, y_I, z_I)$ = B et $(x_{I-1}, y_I, z_I)$ = A et $(x_I, Y_{I-1}, z_I)$ = A et $(x_{I+1}, y_I, z_I)$ = A et $(x_I, y_{I+1}, z_I)$ = A et $(x_I, y_I, z_{I-1})$ = A et $(x_I, y_I, z_{I+1})$ = A (IV) pour l'élément correspondant de la matrice; une réduction de la matrice s'effectuant après que soient déterminés les éléments $(x_I, y_I, z_I)$, qui satisfont (IV), en réduisant de un le nombre de rangées ou le nombre de colonnes ou le nombre de couches de la matrice, selon une séquence prédéterminée, par pas consécutifs, jusqu'à ce qu'il ne reste qu'une matrice (1, 1, 1) ou une matrice nulle, les espaces libres possibles étant toujours déterminés après un pas de réduction à l'aide de (IV); le nombre de rangées étant réduit en retirant des rangées prédéterminées l,l+1 une rangée, en déterminant, pour chaque élément $(x_I, y_I, z_I)$ de la matrice, si oui ou non, $(x_I, y_I, z_I)$ = B et $(x_{I-1}, y_I, z_I)$ = B (V), cas dans lequel l'élément $(x_I, y_I, z_I)'$: = B dans la matrice réduite (x, y, z)' et si (V) n'est pas satisfait, l'élément $(x_I, y_I, z_I)'$ = A; le nombre de colonnes étant réduit en retirant des colonnes prédéterminées l,l+1 une colonne, en déterminant si, oui ou non, $(x_I, y_I, z_I)$ = B et $(x_I, y_{I+1}, z_I)$ = B (VI), cas dans lequel l'élément $(x_I, y_I, z_I)'$: = B dans la matrice réduite (x, y, z)' et si (VI) n'est pas satisfait l'élément $(x_I, y_I, z_I)'$ = A; le nombre de couches étant réduit en retirant des couches prédéterminées l,l+1 une couche, en déterminant si, oui ou non, $(x_I, y_I, z_I)$ = B et $(x_I, y_I, z_{I+1})$ = B (VII), cas dans lequel l'élément $(x_I, y_I, z_I)'$: = B dans la matrice réduite (x, y, z)', et si (VII) n'est pas satisfait, l'élément $(x_I, y_I, z_I)'$ = A; les dimensions des espaces libres déterminés à l'aide de (IV) étant trouvées en créant une table de dimension pour les rangées et pour les colonnes et pour les couches de la matrice et en ajustant la table de dimension pour les rangées, pour les colonnes ou pour les couches dans un pas correspondant au cours de la réduction de la matrice pour faire la somme des dimensions des rangées, des colonnes ou des couches l,l+1.

FIG. 1a

FIG. 1b

[1] (0,y4)-(xm,y5)

[2] (x1,0)-(x5,y2)

[3] (0,y4)-(x5,y6)

[4] (x3,y3)-(xm,y5)

[5] (0,y4)-(x4,y7)

[6] (x6,y3)-(xm,y7)

[7] (x2,y4)-(x4,ym)

[8] (x6,y3)-(x8,y8)

[9] (x3,0)-(x5,y6)

[10] (x7,y1)-(xm,y7)

[11] (x7,y1)-(x8,y8)

[12] (x3,0)-(x4,ym)

FIG. 2